# EUROPEAN PATENT SPECIFICATION

(11) **EP 1 061 659 B1**
(45) Date of publication and mention of the grant of the patent: **15.08.2007**
(21) Application number: 00305057.2
(22) Date of filing: 15.06.2000
(51) Int. Cl.: H04B 1/28, H04B 1/40, H04B 1/18, H03H 7/46

(54) **Muliple-band receiver**
Multibandempfänger
Récepteur multibande

(30) Priority: 18.06.1999 JP 17304399
(43) Date of publication of application: 20.12.2000
(73) Proprietor: FUJITSU TEN LIMITED, Kobe-shi, Hyogo (JP)
(72) Inventor: Sugahara, Shuji, Kobe-shi, Hyogo (JP); Mino, Osamu, Kobe-shi, Hyogo (JP)
(74) Representative: Skone James, Robert Edmund

(56) References cited:
- EP-A- 0 872 953
- US-A- 4 910 481
- US-A- 5 212 813
- US-A- 5 815 804

## Description

The present invention relates to a multiple-band receiver for receiving broadcast signals that are broadcast in two or more frequency bands such as the L band at 1.5 GHz or band III at 200 MHz in DAB (Digital Audio Broadcasting) that has begun in Europe.

Among antennas for receiving DAB broadcasting programs, there is an antenna that receives both L band and band III signals. Signals that have been received by this antenna are guided to a receiver through a common transmission path. In the receiver, each signal is sent to a receiving circuit of a corresponding frequency through a switch using a diode, an FET or the like to allow processing of each signal in the corresponding receiving circuit. In other words, a diode switch or an FET switch is controlled as follows. When a station of the L band has been selected, the antenna is connected to an L-band receiving circuit, and when a station of the band III has been selected, the antenna is connected to a band-III receiving circuit.

There is also other type of receiver having a frequency converter for converting the L band frequency to the band III frequency. In this case, a diode switch or an FET switch is controlled such that the frequency converter is bypassed when band III has been selected.

In the above multiple-band receiver of the type using two kinds of receiving circuits, a receiving circuit that has not been selected remains as a load and the signal level of a selected receiving circuit becomes low because of a lack of isolation in the switch. Thus, there has been a problem of low sensitivity. The multiple-band receiver of the type using a frequency converter also has a similar problem in that, during reception of a band-III signal, an IF signal from the L band interferes with the reception of the band-III signal because of a lack of isolation in the switch.

EP-A-0747988 discloses a high-frequency composite component such as a diplexer in which a receiving input circuit is provided with two sub-receiving input circuits connected in parallel. Each sub-receiving input circuit comprises the following components in series. A phase shifter, a trap circuit, an amplifier, a filter, a further trap circuit, and a further phase shifter. The filters operate at different frequency bands and the trap circuits of one sub-receiving input circuit traps frequencies which are filtered in the other.

US-A-5258728 discloses a band-pass filter having a capacitive reactance at the antenna side and also a band-rejection filter including a parallel resonance circuit connected in series with a receiving circuit.

In accordance with the present invention, a multiple-band receiver for receiving a first frequency band and a second frequency band lower than the first frequency band, the multiple-band receiver comprises a band-pass filter provided between a receiving circuit for receiving the first frequency band and an antenna input, and having a dielectric resonator for passing only the first frequency band; and
a band-rejection filter provided between a receiving circuit for receiving the second frequency band and an antenna input, for rejecting only the first frequency band and is characterized in that the band-pass filter and the band-rejection filter are directly connected to the antenna input; in that the resonator comprises a coaxial dielectric resonator capacity-coupled to input/output terminals of the band-pass filter; and in that the receiver further comprises
a gain-variable high-frequency amplifier (32) for amplifying a signal in the second frequency band that has passed through the band-rejection filter (12); and
a frequency converter (44) for converting the frequency of a signal in the first frequency band that has passed through the band-pass filter (14) into the frequency of the second frequency band, wherein
an output of the frequency converter (44) is coupled to an output of the high-frequency amplifier (32), and the gain of the high-frequency amplifier is minimized when the receiver receives a signal in the first frequency band.

The present invention provides a simple multiple-band receiver having satisfactory characteristics without using a switch.
Fig. 1 is a diagram showing a multiple-band receiver according to a first embodiment of the present invention.
Fig. 2 is a perspective view showing an appearance of a band-pass filter 14.
Fig. 3 is a diagram showing an equivalent circuit of the band-pass filter 14.
Fig. 4 is a block diagram showing a multiple-band receiver according to a second embodiment of the present invention.
Fig. 5 is a diagram showing details of a band-rejection filter 12.
Fig. 6 is a diagram showing another example of a band-rejection filter.

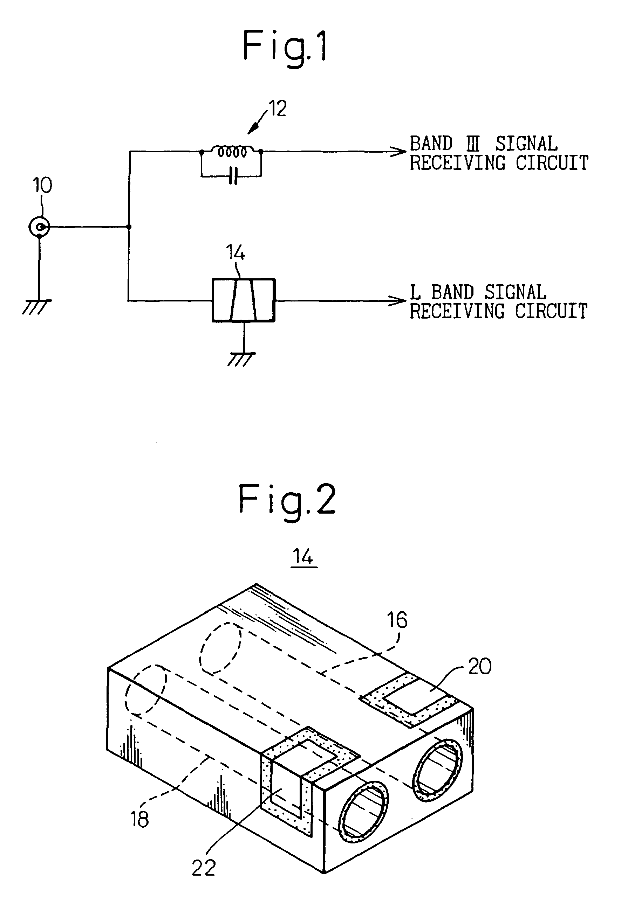

Fig. 1 shows an outline of a receiver for receiving DAB signals, according to an embodiment of the present invention.

Referring to Fig. 1, a parallel resonance circuit 12 consisting of a parallel connection of a capacitor and a coil is inserted between the antenna input-terminal 10 and the band-III receiving circuit in series with the band-III receiving circuit. The resonant frequency of the parallel resonance circuit 12 is 1.5 GHz for the L band. Therefore, the parallel resonance circuit 12 has maximum impedance to prevent the L band signals from passing. The input impedance viewed from the antenna input terminal 10 toward the band-III receiving circuit is sufficiently higher than signal-source impedance at the antenna side. Therefore, the input impedance does not become a load at the L band, and thus does not influence the reception at the L-band signal.

The impedance at another band, such as band III at 200 MHz, for example, becomes low. Therefore, a signal is supplied to the band-III receiving circuit.

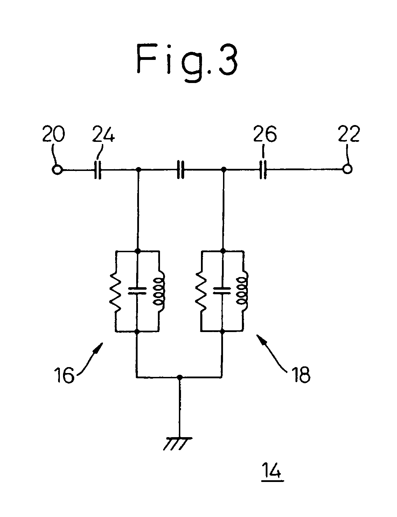

A band-pass filter 14 having a dielectric resonator is inserted between the antenna input-terminal 10 and an L-band receiving circuit. Fig. 2 shows the appearance of the band-pass filter 14, and Fig. 3 shows an equivalent circuit of the band-pass filter 14. Two coaxial resonant conductors 16 and 18 are capacity-coupled to input/output terminals 20 and 22 respectively. The capacity couplings are expressed as capacitive reactances 24 and 26 in the equivalent circuit shown in Fig. 3. The length of each of the coaxial resonant conductors 16 and 18 is λ/4 for the 1.5 GHz L band. Therefore, only a signal in the L band passes through the coaxial resonant conductors 16 and 18, and is supplied to the L-band signal receiving circuit. Transmission of other signals such as band-III signals at 200 MHz, for example, is inhibited. Only the capacitive reactance 24 at the antenna side is inserted in parallel, and it has sufficiently higher impedance than the signal-source impedance. Therefore, this impedance does not become a load on the band-III signal, and does not influence the reception at band III. In the case of using a direct-coupled band-pass filter having an input terminal directly coupled to the resonant conductor, it is necessary to insert a capacitive reactance element into the antenna side to provide high impedance to the band III.

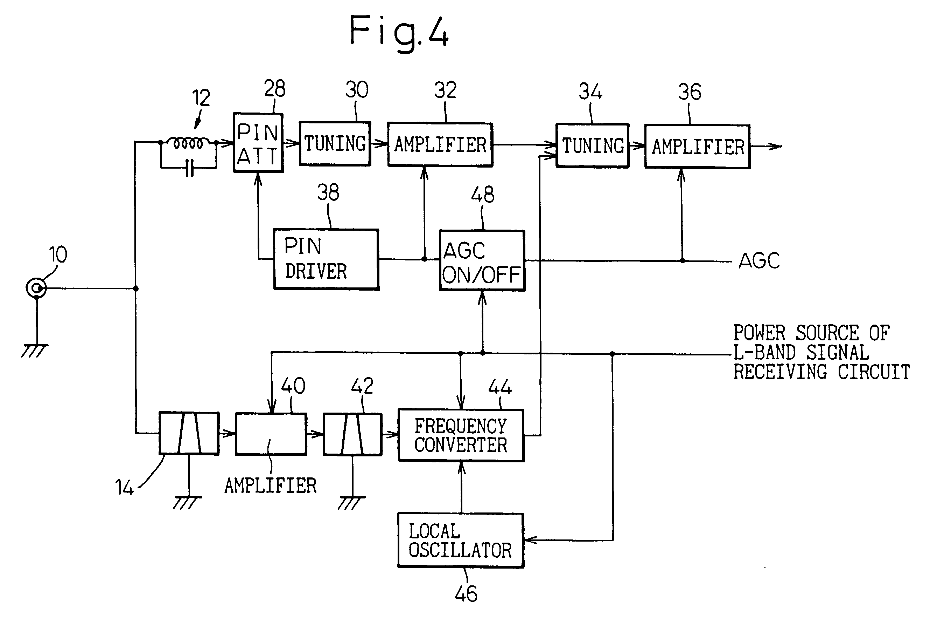

Fig. 4 shows a construction of a multiple-band receiver according to a second embodiment of the present invention. In the multiple-band receiver shown in Fig. 4, a frequency converter converts the frequency of a received signal in the L band to a frequency in band III. Thus, a part of a receiving circuit is commonly used for the L band and for band III. Therefore, a power supply to a circuit for exclusively receiving a signal of the L band is disconnected at the time of receiving a signal in band III. The amplification of an amplifier for exclusively receiving a signal of the band III is lowered at the time of receiving a signal of the L band. Thus, mutual interference is prevented.

In Fig. 4, on the band III side, a signal that has passed through a parallel resonance circuit 12 passes through a PIN attenuator 28, a tuning circuit 30, an amplifier 32, a tuning circuit 34 and an amplifier circuit 36, and is output as an RF signal. The PIN attenuator 28 includes a PIN diode connected in parallel with the circuit, and a PIN driver 38 controls a forward current to control the size of the signal. On the L-band side, a signal that has passed through a band-pass filter 14 passes through an amplifier 40, a band-pass filter 42 and a frequency converter 44, and is supplied to the tuning circuit 34. The frequency converter 44 mixes a local oscillation signal from a local oscillation circuit 46 with the signal from the band-pass filter 42, and converts the frequency.

During reception of a band-III signal, the power supply to the amplifier 40 for receiving an L-band signal, the frequency converter 44 and the local oscillation circuit is disconnected. During reception of an L-band signal, power is supplied to the amplifier 40, the frequency converter 44 and the local oscillation circuit. At the same time, an AGC ON/OFF circuit 48 lowers the gain of the amplifier 32 regardless of an AGC control voltage, and maximizes the forward current of the PIN diode of the PIN attenuator 28. Thus, interference by the band-III signal is prevented.

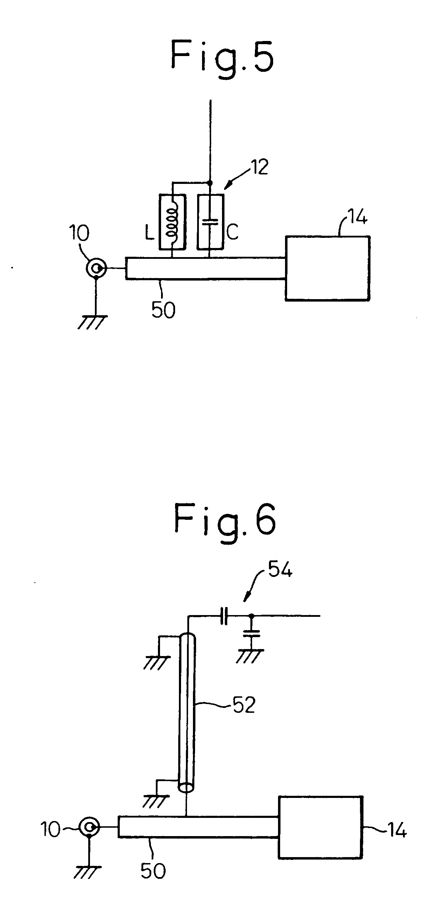

In the above-described construction, a signal is guided from the antenna terminal 10 to the band-pass filter 14 through a microstrip line. However, it is preferable that the inductance and the capacitance that constitute a band-rejection filter 12 are provided near this microstrip line 50 as shown in Fig. 5. With this arrangement, it is possible to avoid a reduction in the level of an L-band signal due to the branched strip lines. Instead of using the inductance and the capacitance, it is also possible to use a coaxial line 52 of a length λ/4 for the L band as shown in Fig. 6. In the L band, the coaxial line 52 is terminated by a capacitor 54.

Depending on the situation, a neon tube or a varistor or the like is provided between the antenna terminal and the earth plane for protecting the antenna terminal from electrostatic damage. In this case, it is possible to prevent the reception characteristics of an L-band signal from being aggravated by the provision of the neon tube or the varistor at a later stage in the band-rejection filter 12.

As explained above, according to the present invention, it is possible to provide a multiple-band receiver for receiving signals of a plurality of bands without using a switch.

## Claims

1. A multiple-band receiver for receiving a first frequency band and a second frequency band lower than the first frequency band, the multiple-band receiver comprising:
a band-pass filter (14) provided between a receiving circuit for receiving the first frequency band and an antenna input (10), and having a dielectric resonator for passing only the first frequency band; and
a band-rejection filter (12) provided between a receiving circuit for receiving the second frequency band and an antenna input (10), for rejecting only the first frequency band, wherein the band-pass filter (14) and the band-rejection filter (12) are directly connected to the antenna input (10); in that the resonator comprises a coaxial dielectric resonator capacity-coupled to input/output terminals (20,22) of the band-pass filter (14); **characterized in that** the receiver further comprises
a gain-variable high-frequency amplifier (32) for amplifying a signal in the second frequency band that has passed through the band-rejection filter (12); and
a frequency converter (44) for converting the frequency of a signal in the first frequency band that has passed through the band-pass filter (14) into the frequency of the second frequency band, wherein
an output of the frequency converter (44) is coupled to an output of the high-frequency amplifier (32), and the gain of the high-frequency amplifier is minimized when the receiver receives a signal in the first frequency band.

2. A receiver according to claim 1, wherein the band-rejection filter (12) is coupled to a strip line provided between the band-pass filter (14) and the antenna input (10).

3. A receiver according to claim 1 or claim 2, wherein the band-pass filter (14) has a capacitive reactance in the first frequency band at the antenna side of the dielectric resonator.

4. A receiver according to any of claims 1 to 3, wherein the band-rejection filter (12) includes a parallel resonance circuit connected in series with the receiving circuit and having a resonance frequency at the first frequency band.

5. A receiver according to any of claims 1 to 4, wherein, the band-rejection filter (12) includes a coaxial line having an electric length of λ/4 at the first frequency band.

## Patentansprüche

1. Mehrbandempfänger zum Empfang eines ersten Frequenzbandes und eines zweiten Frequenzbandes, das niedriger als das erste Frequenzband ist, wobei der Mehrbandempfänger Folgendes umfasst:
einen Bandpassfilter (14), der zwischen einem Empfangskreis zum Empfang des ersten Frequenzbandes und einem Antenneneingang (10) bereitgestellt ist, und der über einen dielektrischen Resonator verfügt, um nur das erste Frequenzband durchzulassen; und
einen Bandsperrfilter (12), der zwischen einem Empfangskreis zum Empfang des zweiten Frequenzbandes und einem Antenneneingang (10) bereitgestellt ist, um nur das erste Frequenzband zu sperren, wobei der Bandpassfilter (14) und der Bandsperrfilter (12) direkt mit dem Antenneneingang (10) verbunden sind; wobei der Resonator einen koaxialen dielektrischen Resonator umfasst, der mit Eingangs-/Ausgangsklemmen (20,22) des Bandpassfilters (14) kapazitivgekoppelt ist; **dadurch gekennzeichnet, dass** der Empfänger weiterhin Folgendes umfasst:
einen verstärkungsvariablen Hochfrequenzverstärker (32) zur Verstärkung eines Signals in dem zweiten Frequenzband, das den Bandsperrfilter (12) passiert hat; und
einen Frequenzumwandler (44) zur Umwandlung der Frequenz eines Signals in dem ersten Frequenzband, das den Bandpassfilter (14) passiert hat, in die Frequenz des zweiten Frequenzbandes, bei dem
ein Ausgang des Frequenzumwandlers (44) an einen Ausgang des Hochfrequenzverstärkers (32) gekoppelt ist und die Verstärkung des Hochfrequenzverstärkers minimiert wird, wenn der Empfänger ein Signal im ersten Frequenzband empfängt.

2. Empfänger nach Anspruch 1, bei dem die Bandsperre (12) mit einer Streifenleitung gekoppelt ist, die zwischen dem Bandpassfilter (14) und dem Antenneneingang (10) bereitgestellt ist.

3. Empfänger nach Anspruch 1 oder Anspruch 2, bei dem der Bandpassfilter (14) über eine kapazitive Reaktanz in dem ersten Frequenzband an der Antennenseite des dielektrischen Resonators verfügt.

4. Empfänger nach einem der Ansprüche 1 bis 3, bei dem der Bandsperrfilter (12) einen parallelen Resonanzkreis umfasst, der mit dem Empfangskreis in Reihe verbunden ist und über eine Resonanzfrequenz am ersten Frequenzband verfügt.

5. Empfänger nach einem der Ansprüche 1 bis 4, bei dem der Bandsperrfilter (12) eine koaxiale Leitung umfasst, die eine elektrische Länge von λ/4 bei dem ersten Frequenzband besitzt.

## Revendications

1. Récepteur à bande multiple destiné à recevoir une première bande de fréquence et une deuxième bande de fréquence inférieure à la première bande de fréquence, le récepteur à bande multiple comprenant :
un filtre passe-bande (14) prévu entre un circuit de réception pour recevoir la première bande de fréquence et une entrée d'antenne (10), et ayant un résonateur diélectrique pour passer seulement la première bande de fréquence ; et
un filtre à élimination de bande (12) prévu entre un circuit de réception pour recevoir la deuxième bande de fréquence et une entrée d'antenne (10), pour éliminer seulement la première bande de fréquence, dans lequel le filtre passe-bande (14) et le filtre à élimination de bande (12) sont connectés directement à l'entrée d'antenne (10) ; en ce que le résonateur comprend un résonateur diélectrique coaxial raccordé en capacité aux terminaux d'entrée/de sortie (20, 22) du filtre passe-bande (14) ; **caractérisé en ce que** le récepteur comprend en outre
un amplificateur haute fréquence à gain variable (32) pour amplifier un signal dans la deuxième bande de fréquence qui est passé par le filtre à élimination de bande (12) ; et
un convertisseur de fréquence (44) pour convertir la fréquence d'un signal dans la première bande de fréquence qui est passé par le filtre passe-bande (14) en fréquence de la deuxième bande de fréquence, dans lequel
une sortie du convertisseur de fréquence (44) est raccordée à une sortie de l'amplificateur haute fréquence (32), et le gain de l'amplificateur haute fréquence est minimisé lorsque le récepteur reçoit un signal dans la première bande de fréquence.

2. Récepteur selon la revendication 1, dans lequel le filtre à élimination de bande (12) est raccordé à une ligne à ruban prévue entre le filtre passe-bande (14) et l'entrée d'antenne (10).

3. Récepteur selon la revendication 1 ou la revendication 2, dans lequel le filtre passe-bande (14) a une réactance capacitive dans la première bande de fréquence au niveau du côté de l'antenne du résonateur diélectrique.

4. Récepteur selon l'une quelconque des revendications 1 à 3, dans lequel le filtre à élimination de bande (12) comprend un circuit de résonance parallèle connecté en série au circuit de réception et ayant une fréquence de résonance à la première bande de fréquence.

5. Récepteur selon l'une quelconque des revendications 1 à 4, dans lequel, le filtre à élimination de bande (12) comprend une ligne coaxiale ayant une longueur électrique de λ/4 à la première bande de fréquence.
